# EUROPEAN PATENT SPECIFICATION

(11) **EP 4 443 907 B1**
(45) Date of publication and mention of the grant of the patent: **02.12.2026**
(21) Application number: 22898235.1
(22) Date of filing: 04.10.2022
(51) Int. Cl.: B06B 1/06, C04B 35/491, H04R 17/00, H10N 30/097, H10N 30/20, H10N 30/30, H10N 30/50, H10N 30/60, H10N 30/853, H10N 30/87, H10N 30/88

(54) **ULTRASONIC TRANSDUCER AND METHOD FOR MANUFACTURING SAME**
ULTRASCHALLWANDLER UND VERFAHREN ZUR HERSTELLUNG DAVON
TRANSDUCTEUR ULTRASONORE ET PROCÉDÉ DE FABRICATION CORRESPONDANT

(30) Priority: 29.11.2021 JP 2021193286
(43) Date of publication of application: 09.10.2024
(73) Proprietor: Murata Manufacturing Co., Ltd., Nagaokakyo-shi, Kyoto 617-8555 (JP)
(72) Inventor: KORESAWA, Kenji, Nagaokakyo-shi, Kyoto 617-8555 (JP); SUZUKI, Yusuke, Nagaokakyo-shi, Kyoto 617-8555 (JP); NOMURA, Junichi, Nagaokakyo-shi, Kyoto 617-8555 (JP); MATSUSHITA, Tomoaki, Nagaokakyo-shi, Kyoto 617-8555 (JP); FUJITA, Akio, Nagaokakyo-shi, Kyoto 617-8555 (JP); FUJII, Kazuhiko, Nagaokakyo-shi, Kyoto 617-8555 (JP)
(74) Representative: Reddie & Grose LLP
(86) International application number: PCT/JP2022/037055
(87) International publication number: WO 2023/095450

(56) References cited:
- CN-A- 111 848 164
- JP-A- 2000 169 223
- JP-A- 2000 169 223
- JP-A- 2017 157 830
- JP-A- H02 270 383
- JP-A- H09 142 931
- JP-A- S4 727 396
- JP-A- S5 361 097
- JP-B2- 2 651 140

## Description

### TECHNICAL FIELD

The present invention relates to an ultrasonic transducer and a method of manufacturing the same.

### BACKGROUND ART

Japanese Patent No. 2651140 is a prior art document disclosing a configuration of an ultrasonic transducer. The ultrasonic transducer disclosed in JP2651140 includes a piezoelectric vibrator, a 1/4 wavelength acoustic matching layer, and a metal case. The piezoelectric vibrator utilizes a spreading vibration mode of a circular piezoelectric substrate.

Japanese Patent Laid-Open No. 2003-23187 is a prior art document disclosing a high heat-resistance piezoelectric element and a piezoelectric device produced using the same. In the high heat-resistance piezoelectric element disclosed in JP2003-23187, the resonance frequency of the piezoelectric resonance in a piezoelectric element before being heat-treated becomes minimum at a temperature in the range of 60°C or higher and 200°C or lower.

JP H09 142931 relates to an ultrasonic transducer that comprises a case having a bottomed cylindrical shape, a bottom portion and a side wall portion: It further comprises a piezoelectric vibrator having piezoelectric ceramic containing Ti and Zr. The piezoelectric vibrator is attached to the bottom portion inside the case. The piezoelectric vibrator is connected to a wire that extend to an outside of the case.

JP2000/169223 discusses a piezoelectric ceramic composition, comprising PbZrO₃-PbTiO₃-Pb(Sn1/3 Sb2/3)O₃, and a method of production.

For the ultrasonic transducer, its shortest detection distance at which a detection target can be detected needs to be 20 cm or less.

The present invention has been made in view of the above-described problems, and aims to provide an ultrasonic transducer and a method of manufacturing the same, by which the shortest detection distance at which a detection target can be detected can be set to be 20 cm or less.

### SUMMARY OF THE INVENTION

The invention is defined in the independent claims to which reference should now be made.

An ultrasonic transducer according to the present invention includes a case, a piezoelectric vibrator, and a wire. The case has a bottomed cylindrical shape, the case having a bottom portion and a side wall portion. The piezoelectric vibrator has piezoelectric ceramic made by firing a lead zirconate titanate-based piezoelectric material in which a content ratio of Ti to Zr is in a range of 0.915 or more and 0.935 or less, the piezoelectric vibrator being attached to the bottom portion inside the case. The wire is connected to the piezoelectric vibrator and disposed to extend to an outside of the case. A resonance frequency in a spreading vibration mode of the piezoelectric ceramic not attached to the bottom portion becomes minimum at a temperature in a range of -30°C or higher and 10°C or lower. A cross-sectional porosity in any longitudinal cross section of the piezoelectric ceramic is 1% or less.

### ADVANTAGEOUS EFFECTS OF INVENTION

According to the present invention, the shortest detection distance at which a detection target can be detected can be set to be 20 cm or less.

### BRIEF DESCRIPTION OF DRAWINGS

Fig. 1 is a longitudinal cross-sectional view showing a configuration of an ultrasonic transducer according to one embodiment of the present invention.
Fig. 2 is an SEM image of a longitudinal cross section of piezoelectric ceramic after being polished, according to Example 1.
Fig. 3 is an SEM image of a longitudinal cross section of piezoelectric ceramic after being polished, according to Comparative Example 3.
Fig. 4 is an SEM image of a longitudinal cross section of piezoelectric ceramic after being polished, according to Comparative Example 5.
Fig. 5 is a graph showing a relation between: an electromechanical coupling coefficient of the piezoelectric ceramic before being attached and an electromechanical coupling coefficient of the piezoelectric ceramic after being attached; and a temperature at which a resonance frequency of the piezoelectric ceramic becomes minimum, in the piezoelectric ceramic in each of Examples 1 to 5 and Comparative Examples 1 to 3.
Fig. 6 is a diagram of a crystal state in a piezoelectric material, which illustrates a relation between a temperature at which the resonance frequency of the piezoelectric ceramic becomes minimum and a composition of the piezoelectric ceramic.
Fig. 7 is a flowchart illustrating a method of manufacturing the ultrasonic transducer according to one embodiment of the present invention.

### DESCRIPTION OF EMBODIMENTS

The following describes an ultrasonic transducer according to one embodiment of the present invention and a method of manufacturing the same with reference to the accompanying drawings. In the following description of the embodiment, the same or corresponding portions in the drawings are denoted by the same reference characters, and the description thereof will not be repeated.

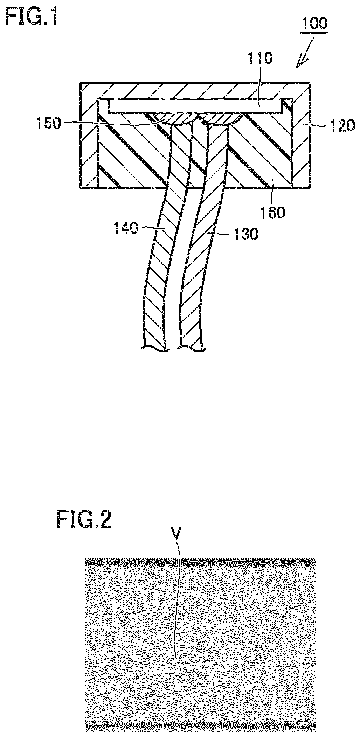

Fig. 1 is a longitudinal cross-sectional view showing a configuration of an ultrasonic transducer according to one embodiment of the present invention. As shown in Fig. 1, an ultrasonic transducer 100 according to one embodiment of the present invention includes a case 120, a piezoelectric vibrator 110, a first wire 130, and a second wire 140. Ultrasonic transducer 100 further includes a bonding material 150 and a sealing material 160. Note that sealing material 160 is not necessarily provided.

Case 120 has a bottomed cylindrical shape and has a bottom portion and a side wall portion. Case 120 is open at its upper end portion on the side opposite to the bottom portion. The bottom portion of case 120 has a disk shape. Note that the shape of the bottom portion of case 120 is not limited to a disk shape but may be a rectangular plate shape or a polygonal plate shape. The side wall portion of case 120 is provided to rise from the peripheral edge of the bottom portion to extend in a direction vertical to the bottom portion. Case 120 is made of aluminum, for example. Case 120 is grounded.

Inside case 120, piezoelectric vibrator 110 is attached to the bottom portion of case 120 with an insulating adhesive such as an epoxy resin. Piezoelectric vibrator 110 has plate-shaped piezoelectric ceramic. When viewed in a direction orthogonal to the bottom portion of case 120, the piezoelectric ceramic has a square shape. The piezoelectric ceramic contains Ti and Zr. The piezoelectric ceramic is made of lead zirconate titanate (PZT)-based ceramic. An electrode is provided on each of main surfaces of the piezoelectric ceramic that face each other.

Each of first wire 130 and second wire 140 is connected to piezoelectric vibrator 110 and disposed to extend to the outside of case 120. Specifically, first wire 130 is electrically connected to the electrode on one main surface of the piezoelectric ceramic through bonding material 150 such as solder. Second wire 140 is electrically connected to the electrode on the other main surface of the piezoelectric ceramic through bonding material 150 such as solder. Fig. 1 shows the state in which second wire 140 is bonded with bonding material 150 to an extended electrode that is connected to the electrode on the other main surface of the piezoelectric ceramic and disposed to extend to the one main surface. In the present embodiment, first wire 130 and second wire 140 each are a lead wire, but may be formed of a flexible printed circuit (an FPC).

When a drive voltage is applied between the electrodes on the piezoelectric ceramic through first wire 130 and second wire 140, piezoelectric vibrator 110 expands in the in-plane direction and vibrates. Vibration of piezoelectric vibrator 110 causes vibration of the bottom portion of case 120.

When the bottom portion of case 120 vibrates in response to ultrasonic waves received from the outside, piezoelectric vibrator 110 also vibrates in accordance with the vibration. When the vibration of piezoelectric vibrator 110 causes electric charge, the ultrasonic wave is converted into an electrical signal by piezoelectric vibrator 110. The electrical signal is transmitted to the outside from an electrode provided on the piezoelectric ceramic through first wire 130 and second wire 140.

Case 120 is filled with sealing material 160. Sealing material 160 fills the space inside case 120. Sealing material 160 is, for example, made of rubber such as silicone rubber or urethane rubber, or made of a resin such as an epoxy resin, and has sound insulating properties and adhesiveness. Note that a sound absorbing material made of a material lower in modulus of elasticity than sealing material 160 may be disposed so as to cover piezoelectric vibrator 110. In this case, sealing material 160 covers the sound absorbing material.

### (Experimental Example)

The following describes an experimental example in which the correlation between the characteristics of the piezoelectric ceramic and the detection distance of the ultrasonic transducer has been verified. In the present experimental example, eleven types of ultrasonic transducers of Examples 1 to 5 and Comparative Examples 1 to 6 were prepared, and their characteristics were verified.

Table 1 summarizes the results of evaluating the characteristics of the piezoelectric ceramic and the ultrasonic transducer according to each of Examples 1 to 5 and Comparative Examples 1 to 6.

**[Table 1]**

| | Process Method | Ti/Zr | Cross-Sectional Porosity (%) | Temperature at which Resonance Frequency Becomes Minimum (°C) | Electromechanical Coupling Coefficient of Attached Piezoelectric Ceramic (%) | Shortest Detection Distance (cm) |
|---|---|---|---|---|---|---|
| Example 1 | Sheet Molding | 0.920 | 0.2 | 0 | 20.3 | 12 |
| Example 2 | Sheet Molding | 0.935 | 1.0 | -30 | 18.7 | 17 |
| Example 3 | Sheet Molding | 0.930 | 0.8 | -20 | 20.4 | 11 |
| Example 4 | Sheet Molding | 0.925 | 0.7 | -10 | 20.7 | 10 |
| Example 5 | Sheet Molding | 0.915 | 0.6 | 10 | 18.0 | 15 |
| Comparative Example 1 | Sheet Molding | 0.950 | 0.3 | -50 | 15.1 | 31 |
| Comparative Example 2 | Sheet Molding | 0.900 | 0.5 | 30 | 14.6 | 32 |
| Comparative Example 3 | Sheet Molding | 0.890 | 0.5 | 50 | 13.2 | 35 |
| Comparative Example 4 | Extrusion Molding | 0.920 | 2.0 | 0 | 16.4 | 27 |
| Comparative Example 5 | Extrusion Molding | 0.935 | 3.0 | -30 | 16.7 | 26 |
| Comparative Example 6 | Press Molding | 0.920 | 6.0 | 0 | 13.3 | 35 |

A lead zirconate titanate-based piezoelectric material used as a material of piezoelectric ceramic was produced by the following method. A prescribed amount of each of PbO powder, TiO₂ powder, ZrO₂ powder, water, a dispersant, and a medium for mixing and grinding was introduced into a container such that the content ratio of Ti to Zr was in the range of 0.89 or more and 0.95 or less. Then, the materials in the container were mixed and ground for 24 hours. After mixing and grinding the materials, the resultant mixture was filtered to remove water, and dried at 100°C to obtain powder. The obtained powder was placed in a sheath made of Al₂O₃ and synthesized at a temperature of about 900°C to 1000°C. The synthesized powder was ground in a dry process, and then subjected to various process methods to prepare a piezoelectric material according to each of Examples 1 to 5 and Comparative Examples 1 to 6. The content ratios of Ti to Zr in the piezoelectric materials according to Examples 1 to 5 and Comparative Examples 1 to 6 are as shown in Table 1.

In each of Examples 1 to 5 and Comparative Examples 1 to 3, the piezoelectric material was sheet-molded. Specifically, a binder, a dispersant, and an antifoaming agent were added to the piezoelectric material to produce slurry. From this slurry, green sheets were produced with the use of a doctor blade method. The obtained green sheets were stacked and pressure-bonded to form a multilayer body, which was then fired to produce piezoelectric ceramic.

In each of Comparative Examples 4 and 5, a piezoelectric material was extrusion-molded. Specifically, a binder and a small amount of water were added to the piezoelectric material to produce a clayey piezoelectric material. Then, from this clayey piezoelectric material, a molded product was formed using an extruder, and this molded product was then fired to produce piezoelectric ceramic.

In Comparative Example 6, a piezoelectric material was press-molded. Specifically, a binder and a dispersant were added to dry powder of the piezoelectric material. Then, from this dry powder, a molded product was formed using a press molding machine, and this molded product was then fired to produce piezoelectric ceramic.

In each of Examples 1 to 5 and Comparative Examples 1 to 6, the obtained piezoelectric ceramic was processed to be formed in a rectangular parallelepiped shape having a one side length of 5 mm and a thickness of 0.2 mm. Then, an electrode made of Ag was formed by sputtering on each of both main surfaces of the piezoelectric ceramic, and then, a direct-current (DC) voltage was applied between these electrodes for polarization. After the polarized piezoelectric ceramic was attached to the bottom portion of case 120 with an adhesive, each of first wire 130 and second wire 140 was electrically connected by bonding material 150 to the electrode on the piezoelectric ceramic. After each of first wire 130 and second wire 140 was pulled out from case 120, case 120 was filled with a resin as sealing material 160 to produce an ultrasonic transducer according to each of Examples 1 to 5 and Comparative Examples 1 to 6.

Further, as a test piece used for obtaining the temperature at which the resonance frequency of the piezoelectric ceramic in each of Examples 1 to 5 and Comparative Examples 1 to 6 became minimum, a test piece was produced in the following way. Specifically, electrodes each made of Ag were formed by sputtering on both main surfaces of the piezoelectric ceramic produced under the same conditions as described above, and then, a DC voltage was applied between the electrodes for polarization to thereby produce a test piece having a long side length of 4 mm, a short side length of 1 mm, and a thickness of 0.2 mm.

The ultrasonic transducer according to each of Examples 1 to 5 and Comparative Examples 1 to 6 was driven to evaluate the shortest detection distance. Further, the equivalent circuit constant in the main vibration mode of the ultrasonic transducer according to each of Examples 1 to 5 and Comparative Examples 1 to 6 was measured with the use of an impedance analyzer. Then, based on the square root of the value obtained by dividing the equivalent capacity by the damping capacity, the electromechanical coupling coefficient of the piezoelectric ceramic after being attached to the bottom portion of case 120 was calculated.

Further, the test piece of the piezoelectric ceramic according to each of Examples 1 to 5 and Comparative Examples 1 to 6 was introduced into a temperature bath, and the temperature was changed by 10-degree (10°C) intervals within a range from -50°C to 200°C, during which the resonance frequency in the spreading vibration mode (31 modes) of each test piece was obtained. Then, a temperature Tfm at which the resonance frequency became minimum was obtained.

Further, after the longitudinal cross section of the piezoelectric ceramic according to each of Examples 1 to 5 and Comparative Examples 1 to 6 was polished, each cross section was observed by a scanning electron microscope (SEM) to evaluate the cross-sectional porosity as the ratio of the area occupied by voids in the piezoelectric ceramic within a range of the field of view.

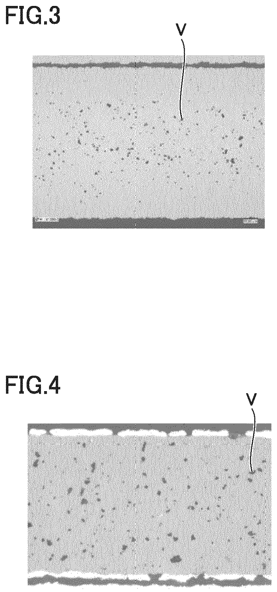

Fig. 2 is an SEM image of the longitudinal cross section of the piezoelectric ceramic after being polished, according to Example 1. Fig. 3 is an SEM image of the longitudinal cross section of the piezoelectric ceramic after being polished, according to Comparative Example 3. Fig. 4 is an SEM image of the longitudinal cross section of the piezoelectric ceramic after being polished, according to Comparative Example 5. In Figs. 2 to 4, a black dot-like portion shows a void V. As shown in Figs. 2 to 4, voids V were small in number in the piezoelectric ceramic according to Example 1 that was produced by sheet-molding a piezoelectric material; voids V were large in number in the piezoelectric ceramic according to Comparative Example 3 that was produced by extrusion-molding a piezoelectric material; and voids V were large in number and size in the piezoelectric ceramic according to Comparative Example 5 that was produced by press-molding a piezoelectric material.

As shown in Table 1, it was found that there was a strong correlation between the shortest detection distance of the ultrasonic transducer and the electromechanical coupling coefficient of the piezoelectric ceramic after being attached, and as the electromechanical coupling coefficient of the piezoelectric ceramic after being attached was higher, the shortest detection distance of the ultrasonic transducer could be shorter.

Thus, as a result of studies conducted for increasing the electromechanical coupling coefficient of the piezoelectric ceramic after being attached, it was found that the electromechanical coupling coefficient of the piezoelectric ceramic after being attached had a correlation between the electromechanical coupling coefficient of the piezoelectric ceramic before being attached and temperature Tfm at which the resonance frequency in the spreading vibration mode (31 modes) of the piezoelectric ceramic became minimum.

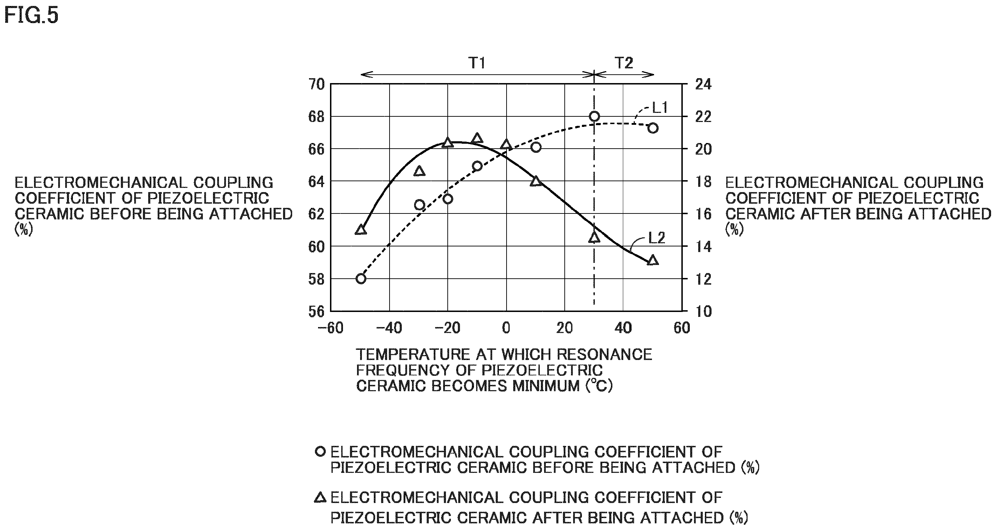

Fig. 5 is a graph showing the relation between: an electromechanical coupling coefficient of the piezoelectric ceramic before being attached and an electromechanical coupling coefficient of the piezoelectric ceramic after being attached; and a temperature at which the resonance frequency of the piezoelectric ceramic becomes minimum, in the piezoelectric ceramic in each of Examples 1 to 5 and Comparative Examples 1 to 3. In Fig. 5, the vertical axis on the left side represents the electromechanical coupling coefficient (%) of the piezoelectric ceramic before being attached, the vertical axis on the right side represents the electromechanical coupling coefficient (%) of the piezoelectric ceramic after being attached, and the horizontal axis represents the temperature (°C) at which the resonance frequency of the piezoelectric ceramic becomes minimum. Further, circular marks each indicate the electromechanical coupling coefficient of the piezoelectric ceramic before being attached, and triangular marks each indicate the electromechanical coupling coefficient of the piezoelectric ceramic after being attached. Also, a dotted line L1 indicates an approximate curve of the transition of the electromechanical coupling coefficient of the piezoelectric ceramic before being attached, and a solid line L2 indicates an approximate curve of the transition of the electromechanical coupling coefficient of the piezoelectric ceramic after being attached.

As shown in Fig. 5, it was found that the electromechanical coupling coefficient of the piezoelectric ceramic before being attached and the electromechanical coupling coefficient of the piezoelectric ceramic after being attached are different from each other in terms of the transition with respect to the change in temperature Tfm at which the resonance frequency in the spreading vibration mode (31 modes) of the piezoelectric ceramic becomes minimum. Specifically, the electromechanical coupling coefficient of the piezoelectric ceramic before being attached and the electromechanical coupling coefficient of the piezoelectric ceramic after being attached were different from each other in terms of temperature Tfm at which these electromechanical coupling coefficients reached their respective peaks. Thus, temperature Tfm at which the electromechanical coupling coefficient of the piezoelectric ceramic before being attached becomes high is equal to a room temperature (about 30°C), whereas temperature Tfm at which the electromechanical coupling coefficient of the piezoelectric ceramic after being attached becomes high is about -15°C This showed that the composition of the piezoelectric ceramic by which the electromechanical coupling coefficient of the piezoelectric ceramic became maximum was different between before and after the piezoelectric ceramic was attached, as will be described later.

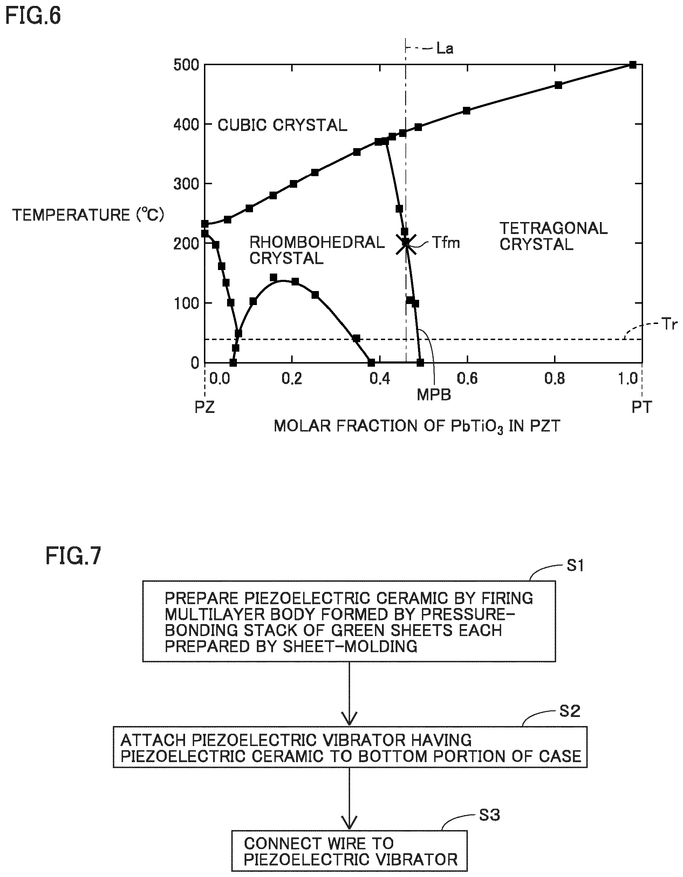

The following describes the relation between the composition of the piezoelectric ceramic and temperature Tfm at which the resonance frequency in the spreading vibration mode (31 modes) of the piezoelectric ceramic becomes minimum. Fig. 6 is a diagram of the crystal state in the piezoelectric material, which illustrates the relation between the temperature at which the resonance frequency of the piezoelectric ceramic becomes minimum and the composition of the piezoelectric ceramic. In Fig. 6, the vertical axis represents the temperature (°C) and the horizontal axis represents the molar fraction of PbTiO₃ in PZT. A room temperature Tr is indicated by a dotted line. When the piezoelectric ceramic has a composition indicated by a dash-dotted line La, the temperature at the point of intersection between this dash-dotted line La and a morphotropic phase boundary MPB is equivalent to temperature Tfm at which the resonance frequency in the spreading vibration mode (31 modes) of the piezoelectric ceramic having the above-mentioned composition becomes minimum. This morphotropic phase boundary MPB is a phase boundary between a rhombohedral crystal and a tetragonal crystal. In other words, changing the content ratio of Ti to Zr in the piezoelectric material makes it possible to adjust temperature Tfm at which the resonance frequency in the spreading vibration mode (31 modes) of the piezoelectric ceramic becomes minimum.

As shown in Fig. 5, in a composition range T1 in which temperature Tfm at which the resonance frequency in the spreading vibration mode (31 modes) of the piezoelectric ceramic becomes minimum is lower than a room temperature indicated by the dash-dotted line, the crystal structure of the piezoelectric ceramic turns into a tetragonal crystal at a room temperature. Also, in a composition range T2 in which temperature Tfm is higher than a room temperature indicated by the dash-dotted line, the crystal structure of the piezoelectric ceramic turns into a rhombohedral crystal at a room temperature.

As shown in Fig. 5, in the piezoelectric ceramic in each of Examples 1 to 5 in which temperature Tfm at which the resonance frequency in the spreading vibration mode (31 modes) of the piezoelectric ceramic became minimum was in the range of -30°C or higher and 10°C or lower, the electromechanical coupling coefficient of the piezoelectric ceramic after being attached was kept as high as 18% or more.

It is considered that this is due to the following reason. Specifically, the electromechanical coupling coefficient of the piezoelectric ceramic itself decreases due to the stress applied to the piezoelectric ceramic when the piezoelectric ceramic is attached to case 120, but the piezoelectric ceramic is prepared to have a composition such that temperature Tfm falls within the range of -30°C or higher and 10°C or lower, and thereby, the piezoelectric ceramic has a stable tetragonal crystal structure at a room temperature, which makes it possible to suppress a decrease in the electromechanical coupling coefficient of the piezoelectric ceramic at the time when the piezoelectric ceramic is attached to case 120.

Conventionally, the composition of the piezoelectric ceramic has been determined such that the electromechanical coupling coefficient of the piezoelectric ceramic before being attached becomes maximum at a room temperature, i.e., such that temperature Tfm at which the resonance frequency in the spreading vibration mode (31 modes) of the piezoelectric ceramic becomes minimum is equal to a room temperature. In this case, as shown in Fig. 5, the electromechanical coupling coefficient of the piezoelectric ceramic after being attached decreases, so that the shortest detection distance of the ultrasonic transducer cannot be shortened.

As shown in Table 1, in each of the ultrasonic transducers according to Examples 1 to 5, the electromechanical coupling coefficient of the piezoelectric ceramic after being attached was kept as high as 18% or more, with the result that the shortest detection distance of the ultrasonic transducer could be set to be 20 cm or less. On the other hand, in each of Comparative Examples 1 to 3 in which temperature Tfm at which the resonance frequency in the spreading vibration mode (31 modes) of the piezoelectric ceramic became minimum was outside the range of -30°C or higher and 10°C or lower, the electromechanical coupling coefficient of the piezoelectric ceramic after being attached was less than 18%, with the result that the shortest detection distance of the ultrasonic transducer could not be set to be 20 cm or less.

As shown in Table 1, in each of the ultrasonic transducers according to Comparative Examples 4 to 6, temperature Tfm at which the resonance frequency in the spreading vibration mode (31 modes) of the piezoelectric ceramic became minimum was in the range of -30°C or higher and 10°C or lower, but the electromechanical coupling coefficient of the piezoelectric ceramic after being attached was less than 18%, with the result that the shortest detection distance of the ultrasonic transducer could not be set to be 20 cm or less.

It is considered that this is because the cross-sectional porosity of the piezoelectric ceramic according to each of Comparative Examples 4 to 6 is greater than 1%, which leads to a significant decrease in the electromechanical coupling coefficient of the piezoelectric ceramic at the time when the piezoelectric ceramic is attached to case 120.

In each of the ultrasonic transducers in Examples 1 to 5, the cross-sectional porosity of the piezoelectric ceramic was 1% or less, which also made it possible to suppress a decrease in the electromechanical coupling coefficient of the piezoelectric ceramic at the time when the piezoelectric ceramic was attached to case 120. As a result, the electromechanical coupling coefficient of the piezoelectric ceramic after being attached was kept as high as 18% or more, and thus, the shortest detection distance of the ultrasonic transducer could be set to be 20 cm or less.

As can be seen from the above-described experimental results, in ultrasonic transducer 100 according to one embodiment of the present invention, the resonance frequency in the spreading vibration mode (31 modes) of the piezoelectric ceramic not attached to the bottom portion of case 120 becomes minimum at temperature Tfm in the range of -30°C or higher and 10°C or lower. The cross-sectional porosity in any longitudinal cross section of the piezoelectric ceramic is 1% or less. Thereby, the electromechanical coupling coefficient of the piezoelectric ceramic after being attached can be kept as high as 18% or more, and thus, the shortest detection distance of ultrasonic transducer 100 can be set to be 20 cm or less.

Preferably, the resonance frequency in the spreading vibration mode of the piezoelectric ceramic not attached to the bottom portion of case 120 becomes minimum at a temperature in the range of -20°C or higher and 0°C or lower. Thereby, the electromechanical coupling coefficient of the piezoelectric ceramic after being attached can be kept as high as 20% or more, and thus, the shortest detection distance of ultrasonic transducer 100 can be set to be 12 cm or less.

Conventionally, piezoelectric ceramic manufactured by a low-cost process such as extrusion molding or press molding has been used for an ultrasonic transducer. However, the ultrasonic transducer according to the present embodiment is manufactured by the following steps, and thus, the shortest detection distance can be set to be 20 cm or less.

Fig. 7 is a flowchart illustrating a method of manufacturing the ultrasonic transducer according to one embodiment of the present invention. As shown in Fig. 7 and Table 1, the method of manufacturing the ultrasonic transducer according to one embodiment of the present invention includes: a step (S1) of preparing piezoelectric ceramic by firing a multilayer body formed by pressure-bonding a stack of a plurality of green sheets, each of the green sheets being prepared by sheet-molding a lead zirconate titanate-based material in which a content ratio of Ti to Zr is in a range of 0.915 or more and 0.935 or less; a step (S2) of attaching a piezoelectric vibrator having the piezoelectric ceramic to a bottom portion of a case having a bottomed cylindrical shape; and a step (S3) of connecting a wire to the piezoelectric vibrator.

In the above description of the embodiment, configurations that can be combined may be combined with each other.

It should be understood that the embodiment and examples disclosed herein are illustrative and non-restrictive in every respect. The scope of the present invention is defined by the scope of the claims.

### REFERENCE SIGNS LIST

100 ultrasonic transducer, 110 piezoelectric vibrator, 120 case, 130 first wire, 140 second wire, 150 bonding material, 160 sealing material.

## Claims

1. An ultrasonic transducer (100) comprising:
a case (120) having a bottomed cylindrical shape, the case having a bottom portion and a side wall portion;
a piezoelectric vibrator (110) having piezoelectric ceramic made by firing a lead zirconate titanate-based piezoelectric material in which a content ratio of Ti to Zr is in a range of 0.915 or more and 0.935 or less, the piezoelectric vibrator being attached to the bottom portion inside the case (120); and
a wire (130, 140) connected to the piezoelectric vibrator (110) and disposed to extend to an outside of the case (120), wherein
a resonance frequency in a spreading vibration mode of the piezoelectric ceramic not attached to the bottom portion becomes minimum at a temperature in a range of -30°C or higher and 10°C or lower, and
a cross-sectional porosity in any longitudinal cross section of the piezoelectric ceramic is 1% or less.

2. The ultrasonic transducer according to claim 1, wherein a resonance frequency in a spreading vibration mode of the piezoelectric ceramic not attached to the bottom portion becomes minimum at a temperature in a range of -20°C or higher and 0°C or lower.

3. The ultrasonic transducer according to claim 1, wherein the bottom portion of the case (120) is disk shaped, rectangular plate shaped or polygonal shaped.

4. A method of manufacturing an ultrasonic transducer (10), the method comprising:
preparing piezoelectric ceramic by firing a multilayer body formed by pressure-bonding a stack of a plurality of green sheets, each of the plurality of green sheets being prepared by sheet-molding a lead zirconate titanate-based material in which a content ratio of Ti to Zr is in a range of 0.915 or more and 0.935 or less;
attaching a piezoelectric vibrator (110) having the piezoelectric ceramic to a bottom portion of a case (120) having a bottomed cylindrical shape; and
connecting a wire (130, 140) to the piezoelectric vibrator.

5. The method according to claim 4, wherein the bottom portion of the case (120) is disk shaped, rectangular plate shaped or polygonal shaped.

## Patentansprüche

1. Ultraschallwandler (100), umfassend:
ein Gehäuse (120) mit einer zylindrischen Form mit Boden, wobei das Gehäuse einen Bodenteil und einen Seitenwandteil aufweist;
einen piezoelektrischen Schwinger (110), der eine piezoelektrische Keramik aufweist, die durch Brennen eines piezoelektrischen Materials auf Basis von Blei-Zirkonat-Titanat hergestellt wird, bei dem das Gehaltsverhältnis von Ti zu Zr im Bereich von 0,915 oder mehr und 0,935 oder weniger liegt, wobei der piezoelektrische Schwinger im Inneren des Gehäuses (120) am Bodenteil angebracht ist; und
einen Draht (130, 140), der mit dem piezoelektrischen Schwinger (110) verbunden ist und so angeordnet ist, dass er sich einer Außenseite des Gehäuses (120) erstreckt, wobei
eine Resonanzfrequenz in einem Ausbreitungsschwingungsmodus der nicht am Bodenteil befestigten piezoelektrischen Keramik bei einer Temperatur in einem Bereich von -30 °C oder höher und 10 °C oder niedriger ein Minimum erreicht, und
eine Querschnittsporosität in jedem Längsquerschnitt der piezoelektrischen Keramik 1 % oder weniger beträgt.

2. Ultraschallwandler nach Anspruch 1, wobei eine Resonanzfrequenz in einem Ausbreitungsschwingungsmodus der nicht am Bodenteil angebrachten piezoelektrischen Keramik bei einer Temperatur in einem Bereich von -20 °C oder höher und 0 °C oder niedriger ein Minimum erreicht.

3. Ultraschallwandler nach Anspruch 1, wobei der Bodenteil des Gehäuses (120) scheibenförmig, rechteckplattenförmig oder polygonförmig ist.

4. Verfahren zur Herstellung eines Ultraschallwandlers (10), das Verfahren umfassend:
Herstellen einer piezoelektrischen Keramik durch Brennen eines Mehrschichtkörpers, der durch Druckverpressen eines Stapels aus einer Mehrzahl von flächigen Rohlingen gebildet wird, wobei jeder der Mehrzahl von flächigen Rohlingen durch Formpressen eines Materials auf Basis von Blei-Zirkonat-Titanat hergestellt wird, bei dem das Gehaltsverhältnis von Ti zu Zr im Bereich von 0,915 oder mehr und 0,935 oder weniger liegt;
Anbringen eines piezoelektrischen Schwingers (110), der die piezoelektrische Keramik aufweist, an einem Bodenteil eines Gehäuses (120) mit einer zylindrischen Form mit Boden; und
Verbinden eines Drahtes (130, 140) mit dem piezoelektrischen Schwinger.

5. Verfahren nach Anspruch 4, wobei der Bodenteil des Gehäuses (120) scheibenförmig, rechteckplattenförmig oder polygonförmig ist.

## Revendications

1. Transducteur à ultrasons (100) comprenant :
un boîtier (120) ayant une forme cylindrique avec fond, le boîtier ayant une partie de fond et une partie de paroi latérale ;
un vibrateur piézoélectrique (110) ayant une céramique piézoélectrique faite par la cuisson d'un matériau piézoélectrique à base de titano-zirconate de plomb dans lequel un rapport de contenu de Ti à Zr est dans une plage de 0,915 ou plus et de 0,935 ou moins, le vibrateur piézoélectrique étant attaché à la partie de fond à l'intérieur du boîtier (120) ; et
un fil (130, 140) connecté au vibrateur piézoélectrique (110) et placé pour s'étendre vers un extérieur du boîtier (120), dans lequel
une fréquence de résonance dans un mode de vibration en extension de la céramique piézoélectrique non attachée à la partie de fond devient un minimum à une température dans une plage de -30 °C ou plus et de 10 °C ou moins, et
une porosité en coupe transversale dans une coupe transversale longitudinale quelconque de la céramique piézoélectrique est de 1 % ou moins.

2. Transducteur à ultrasons selon la revendication 1, dans lequel une fréquence de résonance dans un mode de vibration en extension de la céramique piézoélectrique non attachée à la partie de fond devient un minimum à une température dans une plage de -20 °C ou plus et de 0 °C ou moins.

3. Transducteur à ultrasons selon la revendication 1, dans lequel la partie de fond du boîtier (120) est en forme de disque, en forme de plaque rectangulaire ou de forme polygonale.

4. Procédé de fabrication d'un transducteur à ultrasons (10), le procédé comprenant :
préparer une céramique piézoélectrique par la cuisson d'un corps multicouche formé par le pressage d'un empilement d'une pluralité de feuilles crues, chacune de la pluralité de feuilles crues étant préparée par moulage en feuilles d'un matériau à base de titano-zirconate de plomb dans lequel un rapport de contenu de Ti à Zr est dans une plage de 0,915 ou plus et de 0,935 ou moins ;
attacher un vibrateur piézoélectrique (110) ayant la céramique piézoélectrique à une partie de fond du boîtier (120) ayant une forme cylindrique avec fond ; et
connecter un fil (130, 140) au vibrateur piézoélectrique.

5. Procédé selon la revendication 4, dans lequel la partie de fond du boîtier (120) est en forme de disque, en forme de plaque rectangulaire ou de forme polygonale.
